# EUROPÄISCHE PATENTSCHRIFT

(11) **EP 0 907 970 B1**
(45) Veröffentlichungstag und Bekanntmachung des Hinweises auf die Patenterteilung: **07.11.2007**
(21) Anmeldenummer: 98903213.1
(22) Anmeldetag: 23.02.1998
(51) Int. Cl.: H01L 33/00

(54) **WEISSE LUMINESZENZDIODE**
WHITE LIGHT-EMITTING DIODE
DIODE EMETTANT UNE LUMIERE BLANCHE

(30) Priorität: 03.03.1997 DE 19708407; 18.12.1997 DE 19756360
(43) Veröffentlichungstag der Anmeldung: 14.04.1999
(73) Patentinhaber: Koninklijke Philips Electronics N.V., 5621 BA Eindhoven (NL); Philips Intellectual Property & Standards GmbH, 20099 Hamburg (DE)
(72) Erfinder: JÜSTEL, Thomas, NL-5656 AA Eindhoven (NL); NIKOL, Hans, NL-5656 AA Eindhoven (NL); RONDA, Cees, NL-5656 AA Eindhoven (NL)
(74) Vertreter: Volmer, Georg
(86) Internationale Anmeldenummer: PCT/IB1998/000219
(87) Internationale Veröffentlichungsnummer: WO 1998/039805

(56) Entgegenhaltungen:
- EP-A- 0 446 846
- WO-A-97/48138
- US-A- 3 819 974
- SATO Y ET AL: "FULL-COLOR FLUORESCENT DISPLAY DEVICES USING A NEAR-UV LIGHT-EMITTING DIODE" JAPANESE JOURNAL OF APPLIED PHYSICS, Bd. 35, Nr. 7A, 1.Juli 1996, Seite L838/L839 XP002057391
- NAKAMURA S: "Present performance of InGaN-based blue/green/yellow LEDs" LIGHT-EMITTING DIODES: RESEARCH, MANUFACTURING, AND APPLICATIONS, SAN JOSE, CA, USA, 13-14 FEB. 1997, Bd. 3002, ISSN 0277-786X, PROCEEDINGS OF THE SPIE - THE INTERNATIONAL SOCIETY FOR OPTICAL ENGINEERING, 1997, SPIE-INT. SOC. OPT. ENG, USA, Seiten 26-35, XP002064497
- PATENT ABSTRACTS OF JAPAN vol. 017, no. 542 (E-1441), 29.September 1993 & JP 05 152609 A (NICHIA CHEM IND LTD), 18.Juni 1993,

## Beschreibung

Die Erfindung betrifft eine lichtemittierende Vorrichtung zur Erzeugung von weißem Licht aus einer Lumineszenzdiode und einer Phosphorschicht.

Lumineszenzdioden werden als Signalleuchten, Indikatoranzeigen, Kontroll- und Warnlampen, als Lichtsender in Lichtschranken, für Optokoppler, IR- Fernsteuerungs- und Lichtwellenleiterübertragungssysteme angewendet. Sie bieten eine ganze Reihe von Vorteilen gegenüber anderen lichtemittierenden Bauelementen, z.B. Glühlampen. Sie haben eine hohe Lebensdauer, große Stoß- und Vibrationsfestigkeit, gute Modulierbarkeit bis ins MHZ-Gebiet, hohe Packungsdichten, breite Schaltkreiskompatibilität und keine Einschaltstromspitzen. Sie benötigen eine niedrige Betriebsspannung und haben eine geringe Leistungsaufnahme.

Es war jedoch lange Zeit ein Nachteil der Lumineszenzdioden für sichtbares Licht, daß nicht alle Farben des sichtbaren Lichtes mit der gleichen Leuchtintensität verfügbar waren. Der Wirkungsgrad der Lumineszenzdioden verschlechtert sich mit abnehmender Wellenlänge, d.h. von rot über grün nach blau. Während die Helligkeit von roten und grünen Lumineszenzdioden sehr gut war und durch moderne Herstellungsverfahren noch erheblich gesteigert wurde, hatten blaue Lumineszenzdioden eine verhältnismäßig geringe Lichtintensität. Deshalb war es nicht möglich, mit einfachen Mitteln eine farbneutrale, weiße Beleuchtung durch eine Kombination von Lumineszenzdioden zu erreichen.

Theoretisch läßt sich jede Farbe des sichtbaren Lichtes aus kurzwelligem Licht, d.h. blauem, violettem und ultraviolettem Licht erzeugen. Man kombiniert dazu die Lumineszenzdiode, die kurzwelliges Licht abstrahlt, mit einem geeigneten Phosphor, der das kurzwellige Licht in die gewünschte Farbe konvertiert, indem er das kurzwellige Licht absorbiert und Licht der anderen Farbe im längerwelligen Bereich wieder abstrahlt.

Weißes Licht läßt sich z. B. mit einer blauemittierenden Lumineszenzdiode erzeugen, wenn sie mit einem Phosphor kombiniert wird, der blaues Licht absorbiert, es konvertiert und es als Licht im gelborangenen Bereich des Spektrums abgibt. Das gelborange Licht mischt sich mit dem verbliebenen Anteil des blauen Lichtes aus der Lumineszenzdiode und man erhält aus Blau zusammen mit der Komplementärfarbe Gelb weißes Licht.

Beispielsweise ist aus JP 08007614 A (Patent Abstracts of Japan) eine flächige Lichtquelle bekannt, für die eine lichtemittierende Diode benutzt wird, die blaues Licht emittiert, und die mit einer fluoreszierenden Schicht aus einem orange fluoreszierenden Pigment kombiniert wird, so daß das blaue Licht der Diode als weißes Licht beobachtet werden kann. Ein Nachteil dieser Lichtquelle ist es, daß der Farbton des weißen Lichtes durch die kleine Menge des fluoreszierenden Pigmentes in der fluoreszierenden Schicht stark beeinflußt wird und deshalb schwer zu kontrollieren ist. Nur mit einer hohen Farbtemperatur zwischen 8000 und 8600 K erhält man eine gute Farbwiedergabe. Erniedrigt man die Farbtemperatur, so fällt auch der Farbwiedergabeindex CRI erheblich.

Weiterhin ist aus Jpn.J. Appl. Phys. Vol.35(1996) pp. L838 - L839 eine Lichtquelle bekannt, die eine blaue lichtemittierende Diode, die durch einen hohen Injektionsstrom auch zur Emission von UV-Licht angeregt wird, und einer Leuchtstoffmischung, die ZnS:Ag (blau), ZnS:Cu,Al(grün) und ZnCdS:Ag (rot) umfasst.

In der nicht vorveröffentlichten WO 97/48138 ist eine Lampe aus einem Array von individuellen roten, grünen und blauen phosphorkonverterten UV-LEDs, die individuell angesteuert rotes grünes oder blaues Licht liefern oder gemeinsam angesteuert weißes Mischlicht ergeben, offenbart.

Darüber hinaus sind in EP 0446 846 Farbstoffzubereitungen offenbart, die fluoreszierende Europium-Komplexe enthalten, sowie deren Verwendung in Farbstoffzubereitungen für ein Thermotransfer-Farbdruckverfahren.

Es ist die Aufgabe der vorliegenden Erfindung, eine lichtemittierende Vorrichtung zur Erzeugung von weißem Licht zu schaffen, deren Farbtonwiedergabe leicht zu regulieren ist und dessen Farbwiedergabeindex hoch ist.

Erfindungsgemäß wird die Aufgabe gelöst durch eine lichtemittierende Vorrichtung mit einer UV-Diode mit einer Primäremission von 300 nm ≤ λ≤ 370 nm und mit einer Phosphorschicht mit einer Mischung aus einem blau-emittierenden Phosphor mit einer Emissionsbande mit 430 um ≤ λ ≤ 490 nm, einem grün-emittierenden Phosphor, der ein Linienemitter mit einer Emissionsbande mit einem Wellenlängenmaximum mit 520 nm ≤ λ ≤ 570 nm ist und einem rot-emittierenden Phosphor, der ein Linienemitter mit einer Emissionsbande mit einem Wellenlängenmaximum mit 605 nm ≤ λ ≤ 620 nm ist.

Die lichtemittierende Vorrichtung zeigt eine hohe Farbwiedergabe und gleichzeitig hohe Effizienz, weil die Phosphore die UV-Bande mit hoher Effizienz absorbieren, die Quantenausbeute hoch - über 90% - ist und die Halbwertsbreite der Emissionslinie gering ist. Die Lichtausbeute ist hoch, weil kein Licht im Bereich oberhalb 440 nm und unterhalb 650 nm emittiert wird, wo die Augenempfindlichkeit gering ist. -

Das von der lichtemittierenden Vorrichtung emittierte weiße Licht ist von hoher Qualität. Der Farbwiedergabeindex CRI liegt bei 90 bei einer Farbtemperatur von 4000 K. Die Farbwiedergabe hängt dabei nur von der Zusammensetzung der drei Phosphore ab, nicht von der Relation von konvertiertem zu nichtkonvertiertem Licht und ist deshalb einfach zu kontrollieren und zu regulieren.

Im Rahmen der vorliegenden Erfindung ist es bevorzugt, daß die Phosphore Lanthanid-aktivierte Phosphore sind, insbesondere daß die Phosphore durch Eu(III) oder Tb(III) aktiviert sind.

Es ist ebenso bevorzugt daß der blau-emittierende Phosphor ein Linienemitter mit einer Emissionsbande bei 430nm ≤ λ ≤ 490 nm ist.

Es ist weiterhin bevorzugt, daß die UV-Diode ein GaN-Diode ist.

Im Rahmen der vorliegenden Erfindung kann es bevorzugt sein, daß die Phosphorschicht einen blau-emittierenden Phosphor in einer Menge x1 von 0 < x1 ≤ 30 Gew.-%, einen grün-emittierenden Phosphor in einer Menge x2 von 20 ≤ x2 ≤ 50 Gew.-% und einen rot-emittierenden Phosphor in einer Menge x3 von 30 ≤ x3 ≤ 70 Ges.-% enthält.

Es kann auch bevorzugt sein, daß die Phosphorschicht als blau-emittierenden Phosphor BaMgAl₁₀O₁₇:Eu, als grün-emittierenden Phosphor ZnS:Cu, und als rot-emittierenden Phosphor Y₂O₂S:Eu enthält.

Im Rahmen der vorliegenden Erfindung ist es besonders bevorzugt, daß die Phosphorschicht als rotemittierenden Phosphor einen Phosphor der Zusammensetzung [Eu(diketonat)ₐX_{b1}X'_{b2}], wobei X = Pyridin oder ein einzähniges Pyridinderivat und X' = 2,2'-Bipyridin oder ein 2,2'-Bipyridylderivat und 2a +b₁ +2b₂ = 8 ist, enthält.

Nachfolgend wird die Erfindung anhand einer Figur und drei Ausführungsbeispielen weiter beschrieben.

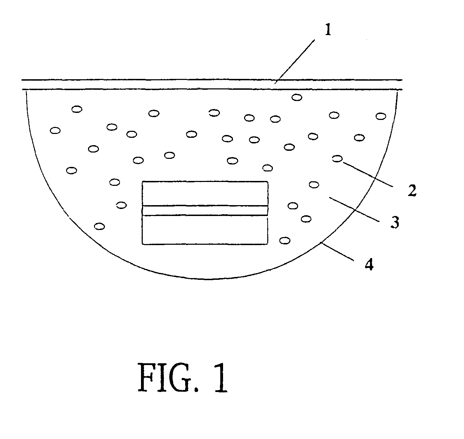

**Fig. 1:** Lichtemittierende Vorrichtung

Eine lichtemittierende Vorrichtung gemäß der Erfindung umfaßt eine UV-Diode als Anregungsquelle für die UV-Strahlung und eine Phosphorschicht, mit einer Mischung aus drei Phosphoren, die das UV-Licht der UV-Diode in sichtbares, weißes Licht umwandeln. In dem in der Zeichnung dargestellten Ausführungsbeispiel ist die Vorrichtung so aufgebaut, daß die UV-Diode in einen halbkugeligen Napf aus einem Polymeren eingegossen ist, der auf einem transparenten Substrat (Frontplatte) **1** angeordnet ist. Die drei Phosphorpulver **2** sind feinverteilt in das Polymere **3** eingebettet. Der Polymerennapf bildet zusammen mit den Phosphorpulvern die Phosphorschicht. Die erfindungsgemäße Vorrichtung kann weiterhin Spiegel **4** für UV- und sichtbares Licht zur Verbesserung der Lichtauskoppelung umfassen. Beispielsweise kann der Napf selbst als Reflektor ausgebildet sein.

Im einfachsten Fall besteht die lichtemittierende Vorrichtung aus einer UV-Diode und einer auf dieser aufgebrachten transparenten Beschichtung, die die Phosphore enthält. Die transparente Beschichtung kann beispielsweise die Phosphore in einer festen Lösung in einer transparenten Matrix aus Polyacrylat, Polystyrol, Epoxyharz oder einem anderen Polymeren enthalten.

Als Massenprodukte werden LEDs üblicherweise in Epoxyharz-Gehäuse vergossen, wobei eine angegossene domförmige Linse aus Epoxidharz zur Verbesserung der Auskoppelung des Lichtes aus der Diode dient. Die Phosphore können bei dieser Ausführungsform als Kontaktschicht zwischen der eigentlichen Diode und dem Epoxyharzdom aufgebracht werden. Sie können auch als Beschichtung außen auf dem Epoxyharzdom aufgebracht sein.

Große, zweidimensionale, lichtemittierende Vorrichtungen können leicht hergestellt werden, indem ein Dioden-Array mit der Phosphorschicht nach der Erfindung kombiniert wird. Beispielsweise kann das Diodenarray durch eine Glasplatte abgedeckt sein, die mit den Phosphoren bedruckt ist.

Die UV-Diode ist insbesondere eine UV-Diode aus InGaN oder GaN und hat ihr Emissionsmaximum zwischen 370 und 410 nm mit einer Halbwertsbreite FWHM < 50 nm.

Zur Aufrechterhaltung der Lichtemission sind Mittel zur Zuführung von elektrischer Energie zu der UV-Diode vorgesehen. Diese Mittel umfassen mindestens zwei Elektroden.

Die drei Phosphore werden so ausgewählt, daß sie durch das UV-Licht der UV-Diode angeregt werden und daß der rote Phosphor eine enge Emissionslinie bei 590 mm ≤ λ ≤ 630 nm , der grüne Phosphor eine enge Emissionslinie bei 520 nm ≤ λ ≤ 570 nm und der blaue Phosphor eine enge Emissionslinie bei 430 nm ≤ λ ≤ 490 nm hat. Für den blauen Phosphor kann statt eines Linienemitters mit einer engen Emissionslinie auch ein Breitbandemitter verwendet werden. Die Emissionslinien der drei Phosphore können sehr genau aufeinander abgestimmt werden, auch wenn die Emissionen nicht ganz unabhängig voneinander sind, da Emissionsflanken teilweise überlappen. Dadurch können die Farbkoordinaten des weißen Lichtes genau eingestellt werden. Die Phosphore sind bevorzugt Lanthanid-aktivierte Phosphore z.B. Eu³⁺ - oder Tb³⁺ -aktivierte Phosphore.

Als rote Phosphore werden Phosphore der Zusammensetzung [Eu(diketonat)ₐX_{b1}X'_{b2}], wobei X = Pyridin oder ein einzähniges Pyridinderivat und X'=2,2'-Bipyridin oder ein 2,2'-Bipyridylderivat und 2a +b₁ +2b₂ = 8 ist, bevorzugt. Diese komplexen Koordinationsverbindungen des Europium(III) enthalten Eu³⁺ als Metallzentrum, Diketonate als anionische Chelatliganden und 2,2'-Bipyridin oder ein 2,2'-Bipyridylderivat als neutrale Chelatliganden. Als Diketonate werden Pentan-2,4-dithionat (acac), 2,2,6,6-Tetramethyl-3,5-heptandithionat (thd), 1-(2-Thenoyl)-4,4,4-trifluor-1,3,butandithionat (ttfa), 7,7-Dimethyl-1,1,1,2,2,3,3-heptafluor-4,6-octandithionat(fod), 4,4,4-Trifluor-1-(2-naphtyl)-1,3-butandithionat (tfnb), 1,3-Diphenyl-1,3-propandithionat (dbm), als neutrale Liganden X Pyridin, oder die zweizähnigen Liganden 2,2'-Bipyridin (bpy), 1,10-Phenanthrolin (phen), 4,7-Diphenyl-1,10-Phenanthrolin (dpphen), 5-Methyl-1,10 phenathrolin (mphen), 4,7-Dimethyl-1,10-phenanthrolin (dmphen), 3,4,7,8- Tetramethyl-1,10-Phenanthrolin (tmphen), 5-Nitro-1,10-Phenanthrolin (NOphen), 5-Chlor-1,10-Phenanthrolin (Clphen) oder Dipyridinphenazin (dppz) verwendet.

In Tab. 1 sind blauemittierenden, grünemittierenden und rotemittierenden Phosphoren mit ihrem Wellenlängenmaximum und ihrer Absorption bei 370 nm angegeben.

**Tab. 1**

| Blauemittierende Phosphore | | | |
|---|---|---|---|
| Komposition | λ [max] | Absorption at 370 nm [%] | QE at 370 nm |
| BaMgAl₁₀O₁₇:Eu | 450 | 70 | 90 |
| Sr₅(PO₄)₃Cl:Eu | 450 | 70 | 90 |
| ZnS:Ag | 450 | 75 | 75 |

| Grünemittierende Phosphore | | | |
|---|---|---|---|
| Komposition | λ [max] | Absorption at 370 nm [%] | QE at 370 nm |
| ZnS:Cu | 550 | 40 | 85 |
| BaMgAl₁₀O₁₇:Eu, Mn | 515 | 70 | 90 |

| Rotemittierende Phosphore | | | |
|---|---|---|---|
| Komposition | λ [max] | Absorption at 370 nm [%] | QE at 370 nm |
| Y₂O₂S:Eu³⁺ | 628 | 30 | 90 |
| YVO₄:Eu³⁺ | 620 | 25 | 85 |
| Y(V,P,B)O₄:Eu³⁺ | 615 | 25 | 85 |
| YNbO₄:Eu³⁺ | 615 | 20 | 90 |
| YTaO₄:Eu³⁺ | 615 | 20 | 90 |
| [Eu(acac)₃(phen)] | 611 | 97 | 70 |

Durch die erfindungsgemäße Mischung wird ein guter Farbwiedergabeindex und gleichzeitig eine gute Energieausbeute erhalten. Die lichtemittierende Vorrichtung hat einen Farbwiedergabeindex CRI < 90 bei einer Farbtemperatur ≥4000 K und eignet sich damit für Innenraumbeleuchtung.

Zur Herstellung der Phosphorschicht können die drei Phosphore als Beschichtung mit einem Bindemittel auf der Dioden-Oberfläche aufgebracht. Als Bindemittel eignen sich beispielsweise filmbildende Acrylpolymerisate wie Methylacrylat und Polystyrol. Alternativ können sie in Mikrogrammengen dem Epoxyharz des Epoxyharzdoms beigemischt werden und gleichmäßig im gesamten Epoxyharzdom verteilt werden. Statt Epoxyharz kann auch ein anderes transparentes Duroplast verwendet werden. Dadurch erhält man eine stärker diffuse Emission des weißen Lichtes. Wegen der großen Helligkeit der lichtemittierenden Vorrichtung kann es aus Sicherheitsgründen erwünscht sein, daß die Lichtemission diffuser ist.

Im Betrieb wird durch die UV-Diode UV-Licht mit einer Wellenlänge λ ≤ 370 nm erzeugt, das auf die Mischung der Phosphore in dem Phosphorschicht fällt. Diese absorbieren die Strahlung und emittieren eine längerwellige Strahlung, d.h. die Phosphore transformieren die unsichtbare UV-Strahlung in sichtbares Licht, welches durch die Phosphore in sichtbares Licht umgewandelt wird. Durch die Mischung der drei Phosphore mit unterschiedlichen Emissionslinien wird das Licht der gewünschten Zusammensetzung erhalten.

Da es sich bei dem Leuchten der erfindungsgemäßen lichtemittierenden Vorrichtung nicht um das von einem glühenden Körper ausgesandte Licht handelt, sondern um das Anregungsleuchten der Phosphore in der Phosphorschicht, ist die Lichtausbeute außerordentlich hoch. Die erfindungsgemäße lichtemittierende Vorrichtung liefert ein angenehmes, farbgetreues Licht. Die im sichtbaren liegenden Emissionslinien der Phosphore liegen so dicht beieinander, daß sich ein quasi-kontinuierliches Spektrum ergibt, woraus eine gute Farbwiedergabe folgt.

### Ausführungsbeispiel 1

Es wurde eine lichtemittierende Vorrichtung aus einer UV-Diode und einer Phosphorschicht mit einer Mischung der drei Phosphore hergestellt. Verwendet wurde eine undotierte GaN-Diode mit transparentem Saphir als Diodensubstrat. Das Diodensubstrat wurde mit einer Suspension aus drei Phosphoren in verschiedenen Mengenverhältnissen gemäß Tab. 2 in einer 1%igen Polyvinylalkohollösung beschichtet und bei 200°C eingebrannt.

**Tab. 2**

| T_{c}[K] | x₁[BaMgAl₁₀O₁₇:Eu] | x₂[ZnS:Cu] | x₃[YVO₄:Eu³⁺] | Ra8 | Phosphor Diode eff. [lm/W] |
|---|---|---|---|---|---|
| 2700 | .04 | .36 | .60 | 85 | 9.7 |
| 3000 | .08 | .37 | .56 | 85 | 9.8 |
| 4000 | .16 | .41 | .43 | 91 | 9.9 |
| 5000 | .22 | .41 | .36 | 92 | 9.6 |
| 6300 | .28 | .43 | .30 | 96 | 9.8 |

### Ausführungsbeispiel 2

Es wurde eine lichtemittierende Vorrichtung aus einer UV-Diode und einer Phosphorschicht mit einer Mischung der drei Phosphore hergestellt. Verwendet wurde eine undotierte GaN-Diode mit transparentem Saphir als Diodensubstrat. Das Diodensubstrat wurde mit einer Suspension aus drei Phosphoren in verschiedenen Mengenverhältnissen gemäß Tab. 2 in einer 1%igen Polyvinylalkohollösung beschichtet und bei 200°C eingebrannt.

**Tab. 3**

| T_{c}[K] | x₁[BAM] | x₂[ZnS:Cu] | x₃[Eu(acac)₃(phen)] | Ra8 | Phosphor Diode eff. [lm/W] |
|---|---|---|---|---|---|
| 2700 | .06 | .36 | .54 | 82 | 12.0 |
| 3000 | .1 | .37 | .49 | 83 | 11.9 |
| 4000 | .18 | .41 | .37 | 89 | 11.8 |
| 5000 | .25 | .41 | .31 | 91 | 11.4 |
| 6300 | .30 | .43 | .25 | 95 | 11.3 |

### Ausführungsbeispiel 3

Es wurde eine lichtemittierende Vorrichtung aus einer UV-Diode und einer Phosphorschicht mit einer Mischung der drei Phosphore hergestellt. Verwendet wurde eine undotierte GaN-Diode mit transparentem Saphir als Diodensubstrat. Das Diodensubstrat wurde mit einer Suspension aus drei Phosphoren in verschiedenen Mengenverhältnissen gemäß Tab. 2 in einer 1%igen Polyvinylalkohollösung beschichtet und bei 200°C eingebrannt.

**Tab. 4**

| T_{c}[K] | x₁[BAM] | x₂[ZnS:Cu] | x₃[Y₂O₂S:Eu³⁺] | Ra8 | Phosphor Diode eff. [Im/W] |
|---|---|---|---|---|---|
| 2700 | 0.05 | 0.31 | 0.63 | 85 | 12.2 |
| 3000 | 0.09 | 0.32 | 0.59 | 85 | 12.2 |
| 4000 | 0.16 | 0.38 | 0.46 | 89 | 12.7 |
| 5000 | 0.23 | 0.38 | 0.39 | 90 | 12.5 |
| 6300 | 0.28 | 0.40 | 0.32 | 95 | 12.5 |

## Patentansprüche

1. Lichtemittierende Vorrichtung mit einer UV-Diode mit einer Primäremission von 300 nm ≤ λ≤ 370 nm und mit einer Phosphorschicht mit einer Mischung aus einem blauemittierenden Phosphor mit einer Emissionsbande mit 430 nm ≤ λ ≤ 490 nm, einem grünemittierenden Phosphor, der ein Linienemitter mit einer Emissionsbande mit einem Wellenlängenmaximum mit 520 nm ≤ λ ≤ 570 nm ist und einem rot-emittierenden Phosphor, der ein Linienemitter mit einer Emissionsbande mit einem Wellenlängenmaximum mit 605 nm ≤ λ ≤ 620 nm ist.

2. Lichtemittierende Vorrichtung gemäß Anspruch 1
**dadurch gekennzeichnet,**
**dass** die Phosphore Lanthanid-aktivierte Phosphore sind.

3. Lichtemittierende Vorrichtung gemäß Anspruch 2
**dadurch gekennzeichnet,**
**dass** die Phosphore durch Eu(III) oder Tb(III) aktiviert sind.

4. Lichtemittierende Vorrichtung gemäß Anspruch 1
**dadurch gekennzeichnet,**
**daß** der blau-emittierende Phosphor ein Linienemitter mit einer Emissionsbande bei 430nm ≤ λ ≤ 490 nm ist.

5. Lichtemittierende Vorrichtung gemäß Anspruch 1,
**dadurch gekennzeichnet,**
**daß** die UV-Diode ein GaN-Diode ist.

6. Lichtemittierende Vorrichtung gemäß Anspruch 1,
**dadurch gekennzeichnet,**
**daß** die Phosphorschicht den blau-emittierenden Phosphor in einer Menge x1 von 0 < x1 ≤ 30 Gew.-%, den grün-emittierenden Phosphor in einer Menge x2 von 20 ≤ x2 ≤ 50 Gew.-% und den rot-emittierenden Phosphor in einer Menge x3 von 30 ≤ x3 ≤ 70 Gew.-% enthält.

7. Lichtemittierende Vorrichtung gemäß Anspruch 1,
**dadurch gekennzeichnet,**
**daß** die Phosphorschicht als blau-emittierenden Phosphor BaMgAl₁₀O₁₇:Eu, als grünemittierenden Phosphor ZnS:Cu, und als rot-emittierenden Phosphor Y₂O₂S:Eu (III) enthält.

8. Lichtemittierende Vorrichtung gemäß Anspruch 1,
**dadurch gekennzeichnet,**
**daß** die Phosphorschicht als rotemittierenden Phosphor einen Phosphor der Zusammensetzung [Eu(diketonat)ₐX_{b1}X'_{b2}], wobei X = Pyridin oder ein einzähniges Pyridinderivat und X' = 2,2'-Bipyridin oder ein 2,2'-Bipyridylderivat und 2a + b₁ + 2b₂ = 8 ist, enthält.

## Claims

1. A light-emitting device comprising an UV-diode with a primary emission of 300 nm ≤ λ ≤ 370 nm and a phosphor layer including a combination of a blue-emitting phosphor having an emission band at 430 nm ≤ λ ≤ 470 nm, a green-emitting phosphor being a line emitter having an emission band with a wavelength maximum of 520 nm ≤ λ < 570 nm, and a red-emitting phosphor being a line emitter having an emission band with a wavelength maximum of 605 nm ≤ λ ≤ 20 nm.

2. A light-emitting device as claimed in claim 1, **characterized in that** the phosphors are lanthanide-activated phosphors.

3. A light-emitting device as claimed in claim 2, **characterized in that** the phosphors are activated by Eu(III) or Tb(III).

4. A light-emitting device as claimed in claim 1, **characterized in that** the blue-emitting phosphor is a line emitter having an emission band at 430 nm ≤ λ ≤ 490 nm.

5. A light-emitting device as claimed in claim 1, **characterized in that** the UV-diode is a GaN diode.

6. A light-emitting device as claimed in claim 1, **characterized in that** the phosphor layer comprises the blue-emitting phosphor in a quantity x1 of 0 < x1 ≤ 30% by weight, the green-emitting phosphor in a quantity x2 of 20 ≤ x2 ≤ 50% by weight and the red-emitting phosphor in a quantity x3 of 30 ≤ 3 ≤ 70% by weight.

7. A light-emitting device as claimed in claim 1, **characterized in that** the phosphor layer comprises BaMgAl₁₀O₁₇:Eu as the blue-emitting phosphor, ZnS:Cu as the green-emitting phosphor and Y₂O₂S:Eu(III) as the red-emitting phosphor.

8. A light-emitting device as claimed in claim 1, **characterized in that** the phosphor layer comprises as the red-emitting phosphor a phosphor of the composition [Eu(diketonate)ₐX_{b1}X'_{b2}], wherein X = pyridine or a monodentate pyridine derivative and X' = 2,2'-bipyridine or a 2,2'-bipyridyl derivative and 2a+b₁+2b₂ = 8.

## Revendications

1. Dispositif émettant de la lumière doté d'une diode UV ayant une émission primaire de 300 nm ≤ λ ≤ 370 nm et avec une couche de phosphore composée d'un mélange de phosphore émettant en bleu avec une gamme d'émission de 430 ≤ λ ≤ 490 nm, un phosphore émettant en vert qui est un émetteur linéaire avec une gamme d'émission d'un maximum de longueur d'ondes de 520 nm ≤ λ ≤ 570 nm et un phosphore émettant en rouge qui est un émetteur linéaire avec une gamme d'émission d'un maximum de longueur d'ondes de 605 nm ≤ λ ≤ 620 nm.

2. Dispositif émettant de la lumière conformément à la revendication 1,
**caractérisé en ce**
**que** les phosphores sont des phosphores activés au lanthanide.

3. Dispositif émettant de la lumière conformément à la revendication 2,
**caractérisé en ce**
**que** les phosphores sont activés par l'Eu(III) ou le Tb(III).

4. Dispositif émettant de la lumière conformément à la revendication 1,
**caractérisé en ce**
**que** le phosphore émettant en bleu est un émetteur de lignes avec une bande d'émission à 430 nm ≤ λ ≤ 490 nm.

5. Dispositif émettant de la lumière conformément à la revendication 1,
**caractérisé en ce**
**que** la diode UV est une diode GaN.

6. Dispositif émettant de la lumière conformément à la revendication 1,
**caractérisé en ce**
**que** la couche de phosphore contient le phosphore émettant en bleu dans une quantité x1 de 0 < x1 ≤ 30 % en poids, un phosphore émettant en vert dans une quantité x2 de 20 ≤ x2 ≤ 50 % en poids et un phosphore émettant en rouge dans une quantité x3 de 30 ≤ x3 ≤ 70 % en poids.

7. Dispositif émettant de la lumière conformément à la revendication 1,
**caractérisé en ce**
**que** la couche de phosphore contient comme phosphore émettant en bleu BaMgAl₁₀O₁₇:Eu, comme phosphore émettant en vert ZnS:Cu et, comme phosphore émettant en rouge, Y₂O₂S:Eu(III).

8. Dispositif émettant de la lumière conformément à la revendication 1,
**caractérisé en ce**
**que** la couche de phosphore contienne comme phosphore émettant en rouge un phosphore de composition [Eu(dicétonate)ₐX_{b1}X'_{b2}], X étant la pyridine ou un dérivé de monopyridine et X' = 2,2'-bipyridine ou un dérivé de 2,2'-bipyridyle et 2a + b₁ + 2b₂ = 8.
